Europäisches Patentamt

(19) European Patent Office   (11) Veröffentlichungsnummer: **0 007 923**
**B1**
Office européen des brevets

(12) **EUROPÄISCHE PATENTSCHRIFT**

(45) Veröffentlichungstag der Patentschrift:       (51) Int. Cl.⁴: **H 01 L 21/31**, H 01 L 21/265
   **27.11.85**

(21) Anmeldenummer: **78100672.1**

(22) Anmeldetag: **16.08.78**

(54) **Verfahren zur Herstellung eines doppeltdiffundierten, lateralen Transistors und eines mit diesem integrierten komplementären vertikalen Transistors.**

(30) Priorität: **31.08.77 US 829302**

(43) Veröffentlichungstag der Anmeldung:
   **20.02.80 Patentblatt 80/4**

(45) Bekanntmachung des Hinweises auf die Patenterteilung:
   **27.11.85 Patentblatt 85/48**

(84) Benannte Vertragsstaaten:
   **DE FR GB**

(56) Entgegenhaltungen:
   **DE - A - 2 157 633**
   **DE - A - 2 534 132**
   **FR - A - 2 372 511**

(73) Patentinhaber: **International Business Machines Corporation, Old Orchard Road, Armonk, N.Y. 10504 (US)**

(72) Erfinder: **Bergeron, David Leo, 7606 Wedgewood Drive, Manassas Virginia 22110 (US)**
   Erfinder: **Putney, Zimri Congdon, 5102 Gunpowder Road, Fairfax Virginia 22030 (US)**
   Erfinder: **Stephens, Geoffrey Brownell, 10 Mercer Court, Catlett Virginia 22019 (US)**

(74) Vertreter: **Gaugel, Heinz, Dipl.-Ing., Schönaicher Strasse 220, D-7030 Böblingen (DE)**

**Beschreibung**

Laterale Transistorstrukturen werden insbesondere bei unter dem Begriff MTL (Merged Transistor Logic) oder I²L (Integrated Injection Logic) bekanntgewordenen bipolaren Strukturen verwendet. Bei diesen Strukturen ist man bemüht, die Grösse der Maskenfenster zu reduzieren, um kleine Emitter-Basis-Diffusionskapazitäten der lateralen PNP-Transistorstruktur, niedrige Kollektor-Basis-Kapazitäten des vertikalen NPN-Transistors, einen niedrigen Basis-Serienwiderstand des lateralen Transistors und eine erhöhte Wahrscheinlichkeit der Vermeidung von Kollektor-Emitter-Kurzschlüssen zu erzielen.

Die bisher bekanntgewordenen Verfahren zur Herstellung derartiger Strukturen gestatten es nicht, selbstausrichtende Maskenfenster für Anschlusszonen bzw. Anschlusskontakte und Schutzringzonen in der Grössenordnung von einem µm zu erzielen. Dies ist jedoch eine Voraussetzung bei der praktischen Verwirklichung von derartigen Strukturen mit minimalem Flächenaufwand und mit einer minimalen Anzahl von kritischen Maskierungs- und Hochtemperaturprozessen.

In der US-PS 4 009 057 ist ein Verfahren zur Herstellung von vertikalen NPN-Transistoren beschrieben, bei dem eine Oxidschicht verwendet wird, in die sämtliche Kontaktfenster geätzt sind, und bei dem dann in aufeinanderfolgenden Verfahrensschritten durch selektive Anwendung von Sperrmasken die gewünschten Strukturen hergestellt werden. Ferner wird unter Verwendung einer Implantationsmaske durch die reoxidierte maskierende Oxidschicht hindurch die Basiszone eines vertikalen Transistors implantiert. Dabei wird die maskierende Oxidschicht schliesslich entfernt und im weiteren Verfahren eine Passivierungsschicht aufgebracht. Dieses bekannte Verfahren gestattet nicht die Herstellung von doppeltdiffundierten, lateralen Transistoren, da eine dicke, die oxidationshindernde Maskierungsschicht aus Siliciumnitrid umgebende Oxidschicht die bekannte «Vogelschnabel»-Ausbildung zufolge hat, die die Basiszone des lateralen PNP-Transistors aufbraucht. Ausserdem bewirkt die Dicke der Oxidschicht (etwa 600 nm), dass die Nitridschicht bei Fenstern in der Grössenordnung von etwa einem µm abspringt. Schliesslich führt die durch Verschiebungen der Nitridschicht durch die Oxidschicht hervorgerufene Spannung im Emitter-Basisbereich des Transistors zu einer Verschlechterung der Eigenschaften, insbesondere bei einem Betrieb mit kleinen Strömen. Nachteilig ist bei dem bekannten Verfahren ausserdem, dass, wie in Fig. 7 der genannten Patentschrift gezeigt, die Nitridschicht von der Oxidschicht abzuheben ist, indem unter der Nitridschicht geätzt wird. Dabei handelt es sich um einen sehr kritischen Prozessschritt, der nur eine geringe Ausbeute zulässt.

(Aus der US-A-3 771 218 ist es bekannt, mit Sperrmasken aus Photolack abdeckbare Fenster für Anschlusszonen eines Transistors in eine Siliziumnitridschicht einzubringen, die auf einer als Passivierungsschicht dienenden Siliziumdioxidschicht aufgebracht ist.)

Der Erfindung liegt die Aufgabe zugrunde, ein Verfahren zur Herstellung eines doppeltdiffundierten, lateralen Transistors in Verbindung mit einem mitintegrierten, komplementären vertikalen Transistor anzugeben (I²L-Struktur), bei dem selbstausrichtende Maskenfenster mit Abmessungen in der Grössenordnung von einem µm oder darunter verwendbar und bei dem eine minimale Anzahl von Hochtemperaturprozessen erforderlich ist. Dabei soll der laterale Transistor eine niedrige Kollektor-Basis-Diffusionskapazität und einen niedrigen Basis-Serienwiderstand und der vertikale Transistor eine reduzierte Kollektor-Basiskapazität aufweisen.

Die Lösung dieser Aufgabe ist durch den Anspruch gekennzeichnet.

Das erfindungsgemässe Verfahren ist von besonderer Bedeutung bei der Herstellung von I²L-Strukturen mit Abmessungen der Maskenfenster in der Grössenordnung von einem µm und darunter. In einem einzigen Prozessschritt werden in der Passivierungsschicht sämtliche Fenster für die Anschlusszonen und die Schutzringzonen erzeugt. Durch Verwendung selektiver Sperrmasken werden über verschiedene Kombinationen dieser Fenster die verschiedenen Zonen der Struktur durch Ionenimplantation hergestellt, was nur eine minimale Anzahl von kritischen Hochtemperaturprozessen erfordert. Die Verwendung von Maskenfenstern mit derart geringen Abmessungen gewährleistet I²L-Strukturen mit reduzierter Kollektor-Basiskapazität des vertikalen Transistors und mit niedriger Emitter-Basis-Diffusions-Kapazität und niedrigem Basis-Serienwiderstand des lateralen Transistors. Gleichzeitig werden mit hoher Wahrscheinlichkeit Störungen durch Kollektor-Emitter-Kurzschlüsse vermieden. Dadurch, dass sämtliche Fenster in der Passivierungsschicht gebildet werden und die verschiedenen implantierten Zonen durch Sperrmasken aus Photolack definiert werden, erhält man I²L-Strukturen, die einen minimalen Flächenbedarf aufweisen und mit einer minimalen Anzahl von kritischen Maskierungsschritten und Hochtemperaturprozessen herstellbar sind.

Ein Ausführungsbeispiel des erfindungsgemässen Verfahrens wird im folgenden näher erläutert.

Es zeigen:

Fig. 1a bis 1i im wesentlichen Schnittansichten einer nach dem erfindungsgemässen Verfahren hergestellten I²L-Struktur in aufeinanderfolgenden Herstellungsstufen.

Beschrieben wird ein erfindungsgemäss verbessertes Verfahren zur Herstellung von I²L-Strukturen (bekannt unter den Begriffen «Merged Transistor Logic» und «Integrad Injection Logic»), das Maskenfenster in der Grössenordnung

von einem µm oder darunter zur Anwendung gelangen lässt. Bei diesem Verfahren werden in einem einzigen Prozessschritt sämtliche Maskenfenster für die Anschlusszonen bzw. Anschlusskontakte und die Schutzringzonen in die Passivierungsschicht eingebracht. Durch Verwendung selektiver Sperrmasken für verschiedene Kombinationen dieser Fenster lassen sich die verschiedenen Zonen der Strukturen mit einer minimalen Anzahl von Hochtemperaturprozessen durch Ionenimplantation einbringen.

Maskenfenster in der Grössenordnung von einem µm und darunter für die Herstellung von Kontaktzonen und Schutzringzonen ergeben I2L-Strukturen, die eine reduzierte Kollektor-Basis-Kapazität des vertikalen NPN-Transistors, eine niedrige Emitter-Basis-Diffusionskapazität des lateralen PNP-Transistors, einen niedrigen Basis-Serienwiderstand des lateralen PNP-Transistors und eine erhöhte Wahrscheinlichkeit der Vermeidung von ungewollten leitenden Verbindungen zwischen Kollektor und Emitter (pipes) aufweisen. Die Herstellung aller Fenster in der Passivierungsschicht und die Verwendung von selektiven Sperrmasken aus Photolack zur Definition der verschiedenen zu implantierenden Zonen ermöglicht die praktische Verwirklichung kleinster, automatisch selbstausgerichteter I2L-Strukturen, wobei eine minimale Anzahl kritischer Maskierungs- und Hochtemperaturprozesse benötigt wird. Durch das Verfahren wird das Ausrichten kritischer Zonen der integrierten Struktur vermieden, und die Selbstausrichtung des Emitters auf die Basis des lateralen PNP-Transistors wie auch die Selbstausrichtung der N-dotierten Schutzringzone auf alle Kontaktfenster und obere Isolationszonen (falls verwendet) wird gewährleistet.

Es wird ein Herstellungsverfahren beschrieben, das die gleichzeitige Herstellung von optimale Eigenschaften aufweisenden NPN- und PNP-Transistoren mit verbesserter Ausrichtung der dotierten Zonen gewährleistet. Beim erfindungsgemässen Verfahren wird von den bekannten Eigenschaften von Siliciumnitrid Gebrauch gemacht, das ein maskiertes Oxidwachstum durchzuführen gestattet und als Ätzmaske für Siliciumdioxid einsetzbar ist.

Die zur Herstellung der in Fig. 1a gezeigten Struktur erforderlichen Verfahrensschritte sind konventionell und umfassen Maskierung, Dotierung (Diffusion oder Ionenimplantation) und Beschichtungen. Dabei werden die vergrabene N+-Schicht 6, die vergrabenen P+-Isolationszonen 10, die N-Epitaxieschicht 4 auf dem Substrat 2, die erste Siliciumdioxidschicht 12 und die Schicht 14 aus Siliciumnitrid gebildet.

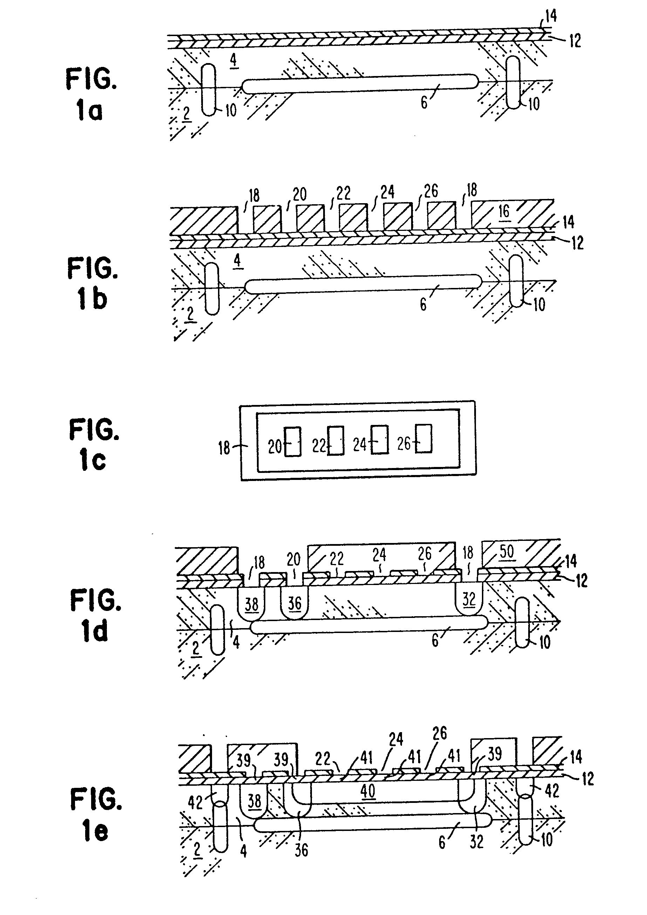

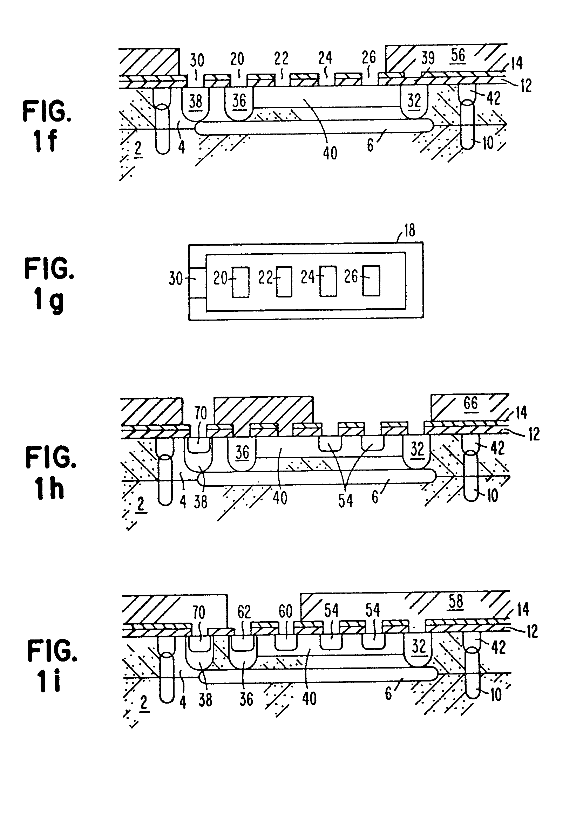

Wie Fig. 1b zeigt, werden sämtliche Maskenfenster für Anschlusszonen bzw. Anschlusskontakte 20, 22, 24, 26 und, falls benutzt, das Fenster für die Schutzringzone 18 durch die Siliciumnitridschicht 14 geätzt, unter Verwendung einer Ätzmaske 16 aus Photolack. In Fig. 1c ist eine Draufsicht dieser Ätzmaske 16 dargestellt.

Ein alternatives Verfahren (nicht durch eine Fig. gekennzeichnet) ergibt sich, wenn anstelle der vergrabenen Isolationszonen 10 lediglich obere Isolationszonen verwendet werden. Diese oberen Isolationszonen können ebenfalls durch die Ätzmaske 16 definiert werden. Nach der Entfernung der Ätzmaske 16 wird eine Sperrmaske aus Photolack aufgebracht, mit deren Hilfe das die obere Isolationszone definierende Fenster in die Siliciumdioxidschicht 12 geätzt wird. Durch Ionenimplantation wird dann die Isolationszone hergestellt. Mit Hilfe eines zusätzlichen Hochtemperaturzyklus werden dann die P+-Isolationszonen durch die Epitaxieschicht 4 getrieben.

In der Struktur gemäss Fig. 1d ist eine erste Sperrmaske 50 aufgebracht, über die im Bereich der Fenster 18 und 20 die Siliciumdioxidschicht 12 entfernt wird und eine Implantation von Phosphor erfolgt. Dabei entsteht die N-dotierte Kontaktierungszone 38 zur vergrabenen Schicht 6, die Schutzringzone 32 und die Basiszone 36 des lateralen PNP-Transistors. Die Implantation erfolgt bei niedriger Energie, so dass die die Fenster 18 und 20 definierenden Schichten 12 und 14 aus Siliciumdioxid und Siliciumnitrid die dotierten Zonen definieren.

Wie Fig. 1e zeigt, wird an einem nachfolgenden Reoxidationsschritt eine zweite Siliciumdioxidschicht 39 im Bereich der Fenster 18 und 20 gebildet. Dieser Reoxidationsprozess läuft etwas langsamer ab als der zur Bildung der ursprünglichen Siliciumdioxidschicht 12, so dass dabei die N-dotierten Zonen 32, 36 und 38 in die ausdiffundierende vergrabene Schicht 6 eindiffundieren. Während dieses Oxidationsschrittes wächst ebenfalls eine dritte Oxidschicht 41 in den Bereichen 22, 24 und 26 derart langsam auf, dass sich dort bei der nachfolgenden Ionenimplantation eine Bremswirkung ergibt, die der der Siliciumdioxidschicht 12 und der Siliciumnitridschicht 14 zusammengenommen entspricht.

Wie in Fig. 1e weiterhin gezeigt, werden im nächsten Verfahrensschritt durch eine Implantation von Bor mit doppelter Energie mit Hilfe einer Maske aus Photolack die oberen Isolationszonen 42 und die Basiszone des vertikalen NPN-Transistors bzw. die Kollektorzone des lateralen PNP-Transistors eingebracht, die eine gemeinsame Zone 40 bilden. Da diese P-dotierten Zonen 40 und 42 durch die Oxidschicht 39 und 41, die Oxidschicht 12 und die Siliciumnitridschicht 14 implantiert werden, ist die Tiefe des Überganges der Basiszone 40 in den Bereichen 22, 24 und 26 abhängig von der Dicke der Oxidschicht 41 und in den übrigen Bereichen abhängig von der Dicke der Oxidschicht 12 einschliesslich der Siliciumnitridschicht 14. Hält man die Dicke der Siliciumnitridschicht klein im Vergleich zur Dicke der Siliciumoxidschicht 39, so werden die Unterschiede in der Tiefe des Überganges der Basiszone 40 klein gehalten. Diese P-dotierte Zone 40 weist einen hohen Schichtwiderstand (1000 Ohm/Flächeneinheit) auf, was eine niedrige Kollektor-Basiskapazität des vertikalen NPN-Transistors und eine hohe Kollektor-Basis-Durchbruchspannung des lateralen PNP-Transistors ergibt. Diese Zone ist gleichzeitig zur Verwendung als Widerstandszone geeignet.

In der Struktur gemäss Fig. 1f ist eine zweite Sperrmaske 56 aus Photolack aufgebracht. Diese Sperrmaske deckt die Schutzringzonen 32 und die oberen Isolationszonen 42 ab, während die Fenster 20, 22, 24, 26 und ein Fenster 30 innerhalb des Fensters 18 in der Siliciumdioxidschicht 12 geöffnet werden. Diese Sperrmaske 56 definiert ausserdem eine oder mehrere Seiten des Fensters 30 für die Kontaktierungszone 38.

In Fig. 1g ist eine Draufsicht der Maskenanordnung dargestellt. Die Fenster 20, 22, 24 und 26 sind durch die Nitridschicht definiert. Das Fenster 30 ist durch die Nitridschicht 14 einerseits und die Sperrmaske 56 andererseits definiert. Die Sperrmaske ist nur erforderlich, wenn eine Schutzringzone 32 und eine obere Isolationszone 42 vorgesehen ist.

In den beiden nächsten Maskierungsschritten werden Sperrmasken aus Photolack als Masken für Ionenimplantationen eingesetzt. Die Reihenfolge der Maskierungsschritte kann umgekehrt werden.

1. Mit Hilfe der dritten Sperrmaske 66 in Fig. 1h werden die Kollektorzonen 54 des vertikalen NPN-Transistors und die laterale Basisanschlusszone 70 der Kontaktierungszone 38 zur vergrabenen Schicht gebildet, die die Basiskontaktierungszone des lateralen PNP-Transistors darstellt. Die Implantationsbereiche selbst werden dabei durch die Fenster in den Schichten 12 und 14 definiert.

2. Die in Fig. 1i gezeigte vierte Sperrmaske 58 dient der Herstellung der Anschlusszone 60 zur gemeinsamen Zone 40, die sowohl die Basiszone des vertikalen als auch die Kollektorzone des lateralen Transistors darstellt, der Emitterzone 62 des lateralen Transistors und eventueller Anschlusszonen zu einer eventuell vorgesehenen entsprechenden Widerstandszone.

Den Implantationsprozessen folgt ein Erwärmungsprozess nach, bei dem die implantierten Zonen aktiviert und die N+- und P+-dotierten Zonen in ihre endgültige Tiefe ausgedehnt werden.

Anstelle einer aus einer vergrabenen und einer oberen Isolationszone zusammengesetzten Isolationszone kann auch eine einfache Isolationszone vorgesehen werden.

Zusammenfassend liefert das erfindungsgemässe Verfahren eine vereinfachte, erweiterbare Prozessfolge, mit der sich folgendes erzielen lässt:

1. Ein gute Betriebseigenschaften aufweisender vertikaler NPN-Transistor mit Kollektorkontaktierungszone, die in bezug auf alle anderen Anschlusszonen automatisch ausgerichtet ist.

2. Ein doppeltdiffundierter, lateraler PNP-Transistor.

3. Hochohmige Widerstände.

4. Schutzringzonen, die in bezug auf sämtliche Anschlusszonen bzw. Kontakte ausgerichtet sind.

5. Obere Isolationszonen, die in bezug auf sämtliche Anschlusszonen bzw. Kontakte und die Schutzringzone automatisch ausgerichtet sind.

Schliesslich gestattet die automatische Ausrichtung eine dichtere Anordnung der dotierten Zonen mit reduzierten Anforderungen an die Maskierungs- und Photoätztechniken.

**Patentanspruch**

1. Verfahren zur Herstellung eines doppeltdiffundierten, lateralen Transistors, integriert mit einem komplementären vertikalen Transistor, in einer Halbleiterschicht eines ersten Leitungstyps mit einer hochdotierten, vergrabenen Schicht des ebenfalls ersten Leitungstyps, dadurch gekennzeichnet, dass in einem ersten Maskierungsschritt ein erstes Fenster (18) für eine Schutzringzone sowie für eine Kontaktierungszone zur vergrabenen Schicht, ein zweites Fenster (20) für die laterale Basiszone sowie für die laterale Emitterzone, ein drittes Fenster (22) für eine Anschlusszone zu einer gemeinsamen Zone, die sowohl die laterale Kollektorzone als auch die vertikale Basiszone bildet, und ein viertes Fenster (24, 26) für die vertikale Kollektorzone in eine Siliciumnitridschicht (14) eingebracht werden, die auf einer als Passivierungsschicht dienenden ersten Siliciumdioxidschicht (12) aufgebracht ist, dass mittels einer das dritte und vierte Fenster (22, 24, 26) abdeckenden ersten Sperrmaske (50) im Bereich des ersten und zweiten Fensters (18, 22) die erste Siliciumdioxidschicht (12) abgeätzt wird und die Schutzringzone (32), die Kontaktierungszone (38) und die laterale Basiszone (36) des ersten Leitungstyps bis zur vergrabenen Schicht (6) reichend eingebracht werden, dass im Bereich des ersten und zweiten Fensters eine zweite Siliciumdioxidschicht (39) aufgebracht wird, dass unter Verwendung einer Implantationsmaske (Fig. 1e) durch die Siliciumdioxidschichten bzw. zusätzlich durch die Siliciumnitridschicht hindurch die gemeinsame Zone (40) des zweiten Leitungstyps implantiert wird, wobei eine Kante der Implantationsmaske dort mit einer Kante des zweiten Fensters (22) zusammenfällt bzw. diese überlappt, wo die gemeinsame Zone (40) die laterale Kollektorzone bildet und wobei die restlichen drei Kanten der Implantationsmaske dort mit drei Kanten der Schutzringzone (32) im ersten Fenster (18) zusammenfallen bzw. diese überlappen, wo die gemeinsame Zone (40) die vertikale Basiszone bildet, dass mittels einer selektiv den Teil des ersten Fensters (18) für die Schutzringzone (32) abdeckenden zweiten Sperrmaske (56) die jeweilige Siliciumdioxidschicht in dem für die Kontaktierungszone (38) vorgesehenen Teil des ersten Fensters und in den Bereichen des zweiten, dritten und vierten Fensters abgeätzt wird, dass unter Verwendung einer das zweite und dritte Fenster abdeckenden dritten Sperrmaske (66) im vierten Fenster die vertikale Kollektorzone (54) und in dem für die Kontaktierungszone (38) vorgesehenen Teil des ersten Fensters die laterale Basisanschlusszone (70) des ersten Leitungstyps implantiert werden und dass unter Verwendung einer den zuletzt genannten Teil des ersten Fensters und das vierte Fenster abdeckenden vierten Sperrmaske im zweiten Fenster die laterale Emitterzone (62) und im dritten Fenster die Anschlusszone (60) zur gemeinsamen Zone des zweiten Leitungstyps implantiert werden.

**Claim**

1. Method of making a double diffused lateral transistor, integrated with a complementary vertical transistor, in a semiconductor layer of a first conductivity type with a highly doped buried layer also of the first conductivity type, characterized in that in a first masking step a first window (18) for a protective ring region as well as for a contacting region to the buried layer, a second window (20) for the lateral base region as well as for the lateral emitter region, a third window (22) for a contact region to a common region which forms the lateral collector region as well as the vertical base region, and a fourth window (24, 26) for the vertical collector region are made in a silicon nitride layer (14) which is applied on a first silicon dioxide layer (12) serving as a passivation layer, that by means of a first blocking mask (50) covering the third and fourth window (22, 24, 26), within the area of the first and second window (18, 22) the first silicon dioxide layer (12) is etched off, and the protective ring region (32), the contacting region (38) and the lateral base region (36) of the first conductivity type are introduced down to the buried layer (6), that in the area of the first and second window a second silicon dioxide layer (39) is applied, that using an implantation mask (Fig. 1e) the common region (40) of the second conductivity type is implanted through the silicon dioxide layers and additionally through the silicon nitride layers, respectively, one edge of the implantation mask coinciding there with an edge of the second window (22), or overlapping it where the common region (40) forms the lateral collector region, and where the remaining three edges of the implantation mask coincide with three edges of the protective ring region (32) in the first window (18), or overlap them where the common region (40) forms the vertical base region, that by means of a second blocking mask (56) selectively covering part of the first window (18) for the protective ring region, the respective silicon dioxide layer is etched off in the part of the first window for the contacting region (38), and in the areas of the second, third and fourth window, that using a third blocking mask (66) provided in the fourth window and covering the second and third window the vertical collector region (54), and in the part of the first window provided for the contacting region (38) the lateral base contact region (70) of the first conductivity type are implanted, and that using a fourth blocking mask in the third window covering the last-mentioned part of the first window and the fourth window, the lateral emitter region (62) in the second window and the connecting region (60) in the third window are implanted to the common region of the second conductivity type.

**Revendication**

1. Procédé pour fabriquer un transistor latéral à double diffusion, intégré avec un transistor vertical complémentaire, dans une couche semiconductrice possédant un premier type de conductivité et comportant une couche ensevelie, fortement dopée et possédant également le premier type de conductivité, caractérisé en ce que, lors d'une première phase de masquage, on aménage une première fenêtre (18) pour une zone annulaire de protection ainsi que pour une zone de contact avec la couche ensevelie, une seconde fenêtre (20) pour la zone de base latérale ainsi que pour la zone d'émetteur latérale, une troisième fenêtre (22) pour une zone de raccordement à une zone commune, qui forme aussi bien la zone de collecteur latérale que la zone de base latérale et une quatrième fenêtre (24, 26) pour la zone de collecteur verticale dans une couche de nitrure de silicium (14), qui est déposée sur une première couche de bioxyde de silicium (12) utilisée en tant que couche de passivation, qu'à l'aide d'un masque d'un premier masque de blocage (50), recouvrant la troisième et la quatrième fenêtres (22, 24, 26), on élimine par attaque chimique la première couche de bioxyde de silicium (12) dans la région de la première et de la seconde fenêtres (18, 22), et on fait pénétrer la zone annulaire de protection (32), la zone de contact (38) de la zone de base latérale (36) possédant le premier type de conductivité jusqu'à ce qu'elles s'étendent jusqu'à la couche ensevelie (6), qu'on dépose une seconde couche de bioxyde de silicium (39) dans la région de la première et de la seconde fenêtres, que moyennant l'utilisation d'un masque d'implantation (figure 1e), on implante la zone commune (40) possédant le second type de conductivité à travers les couches de bioxyde de silicium ou en outre à travers la couche de nitrure de silicium, auquel cas un bord du masque d'implantation coïncide avec un bord de la seconde fenêtre (22) ou recouvre ce bord à l'endroit où la zone commune (40) constitue la zone de collecteur latérale, et les trois autres bords du masque d'implantation coïncident avec trois bords de la zone annulaire de protection (32) dans la première fenêtre (18) ou recouvrent cette dernière à l'endroit où la zone commune (40) forme la zone de base verticale, qu'à l'aide d'un second masque de blocage (56) recouvrant de façon sélective la partie de la première fenêtre (18) prévue pour la zone annulaire de blocage (32), on élimine par attaque chimique la couche respective de bioxyde de silicium dans la partie, prévue pour la zone de contact (38) de la première fenêtre et dans les régions des seconde, troisième et quatrième fenêtres, que moyennant l'utilisation d'un troisième masque de blocage (66) recouvrant la seconde et la troisième fenêtres, on implante la zone de collecteur verticale (54) dans la quatrième fenêtre et la zone latérale de raccordement de base (70) possédant le premier type de conductivité dans la partie de la première fenêtre, prévue pour la zone de contact (38), et que moyennant l'utilisation d'un quatrième masque de blocage recouvrant la partie indiquée en dernier de la première fenêtre et de la quatrième fenêtre, on implante la zone d'émetteur latérale (62) dans la seconde fenêtre et la zone (60) de raccordement à la zone commune possédant le second type de conductivité, dans la troisième fenêtre.

FIG.
1a

FIG.
1b

FIG.
1c

FIG.
1d

FIG.
1e

FIG. 1f

FIG. 1g

FIG. 1h

FIG. 1i